# EUROPÄISCHE PATENTANMELDUNG

(11) **EP 1 544 586 A1**
(43) Veröffentlichungstag der Anmeldung: **22.06.2005**
(21) Anmeldenummer: 04026987.0
(22) Anmeldetag: 12.11.2004
(51) Int. Cl.: G01F 23/38, G01R 33/09

(54) **Sensorelement**

(30) Priorität: 19.12.2003 DE 10360406
(71) Anmelder: TI Automotive (Neuss) GmbH, 41460 Neuss (DE)
(72) Erfinder: Henschel, Matthias, Dr., 77836 Rheinmünster (DE); Schreuder, Peter, 47623 Kevelar (DE); Lahn, Bernd Jürgen, 41844 Wegberg (DE); Kleinen, Alfred, 41849 Wassenberg (DE)
(74) Vertreter: von Kreisler Selting Werner

(57) **Zusammenfassung**

Ein Sensorelement (30) misst eine durch einen bewegbaren Magneten (16) erzeugte Hallspannung. Hierzu weist das Sensorelement (30) ein keramisches Basiselement (40) auf, mit dem ein Detektorelement (46) verbunden ist. Das Detektorelement (46) ist mit Hilfe eines Abdeckelements (42) vor einer aggressiven Umgebung, wie sie durch Kraftstoff oder durch Kraftstoffdämpfe in einem Kraftstofftank (34) eines Kraftfahrzeugs auftreten, geschützt. Mit dem Detektorelement (46) sind elektrische Leiter (60) verbunden, die durch das Abdeckelement (42) und/ oder das Basiselement (40) geführt sind, um das Detektorelement (46) mit einer Spannungsquelle bzw. einer Auswerteeinheit zu verbinden. Durch das Abdeckelement (42) und ggf. mit dem Basiselement (40) ist das Detektorelement (46) sicher von der aggressiven Umgebung abgekapselt, so dass durch einfache konstruktive Maßnahmen die Lebensdauer des Sensorelements (30) erhöht ist.

## Beschreibung

Die Erfindung betrifft ein Sensorelement zur berührungslosen Messung eines Magnetfeldes in aggressiver Umgebung, insbesondere zur Verwendung innerhalb eines Kraftstofftanks eines Kraftfahrzeugs.

Aus DE 101 42 618 A1 ist ein berührungsloser Füllstandgeber bekannt, der zur Messung eines Füllstands in einem Kraftstofftank als Sensorelement einen Hallsensor verwendet, der das Magnetfeld eines Magneten detektiert. Der Magnet ist über einen Hebel mit einem Schwimmer verbunden, so dass sich das gemessene Magnetfeld des Magneten in Abhängigkeit vom Füllstand in dem Kraftstofftank ändert. Der Hebel ist über eine Drehachse drehbar gelagert. Die Drehachse wird von dem als Ringmagneten ausgebildeten Magneten teilweise umfasst. Der Ringmagnet ist hierbei zwischen dem Hallsensor und der Drehachse angeordnet. Der Magnet ist in einem zweistückigen Gehäuse angeordnet, wobei die Gehäusehälften mit Hilfe eines Gießharzes flüssigkeitsdicht verschlossen sind. Zum Schutz vor der aggressiven Umgebung in dem Kraftstofftank ist der Hallsensor in einer in einem Gehäuse eingeformten Tasche angeordnet, die ebenfalls mit Gießharz verfüllt ist.

Nachteilig bei einem derartigen Sensorelement ist, dass erheblicher konstruktiver Aufwand betrieben werden muss, um das Sensorelement zu schützen. Es ist erforderlich, Bauteile mit komplizierten Geometrien zu verwenden, die entsprechend aufwändig und teuer in der Herstellung sind.

Ferner reicht der Schutz des Gießharzes nicht aus, da Kraftstoff, der an der Gehäusewand vorbei in Kontakt mit dem Gießharz kommt, durch dieses allmählich hindurch diffundiert, so dass das Sensorelement beispielsweise durch Korrosion beschädigt wird, so dass die Lebensdauer verhältnismäßig kurz ist.

Aufgabe der Erfindung ist es, ein Sensorelement mit einer in einer aggressiven Umgebung erhöhten Lebensdauer zu schaffen.

Die Aufgabe wird erfindungsgemäß gelöst durch ein Sensorelement mit den Merkmalen des Anspruchs 1.

Das erfindungsgemäße Sensorelement, mit dem ein durch einen bewegbaren Magneten erzeugtes Magnetfeld gemessen wird, weist ein Basiselement auf, das aus einem elektrischen Isolatormaterial, insbesondere eine Keramik, wie beispielsweise Al₂O₃, besteht. Mit dem Basiselement ist ein Detektorelement verbunden, das über einen physikalischen Effekt, z. B. Hallefekt, die Richtung und/ oder Stärke des Magnetfeldes detektiert. Ferner ist mit dem Basiselement ein metallisches Abdeckelement verbunden. Das Abdeckelement ist von dem Detektorelement beabstandet, d.h. das Detektorelement ist ohne einen direkten elektrischen Kontakt durch das Abdeckelement abgedeckt und von der Umgebung geschützt. Mit dem Detektorelement sind elektrische Leiter verbunden, die durch das Abdeckelement und/ oder durch das Basiselement zur Verbindung mit einer Spannungsquelle bzw. einer Auswerteeinheit geführt sind.

Durch das Abdeckelement und ggf. zusätzlich durch das Basiselement ist das Detektorelement von der Umgebung weitestgehend abgeschlossen. Das metallische Abdeckelement und ggf. das Basiselement sind zumindest für Kraftstoff diffusionsbeständig, d.h. ein diffusiver Stofftransport durch das Abdeckelement bzw. ggf. durch das Basiselement hindurch ist im Gegensatz zu Gießharz oder Kunststoff nicht nachweisbar. Sofern zwischen dem Abdeckelement und dem Basiselement Verbindungsstellen auftreten, die von der aggressiven Umgebung her zugänglich sind, erfolgt die Verbindung zwischen dem Abdeckelement und dem Basiselement an diesen Stellen vorzugsweise stoffschlüssig, beispielsweise durch Löten, so dass auch die Verbindungsstellen zumindest für Kraftstoff diffusionsbeständig sind. Zur verbesserten Lötfähigkeit des metallischen Abdeckelements mit dem Basiselement handelt es sich bei dem Basiselement beispielsweise um eine lötfähige metallisierte Keramik, so dass zumindest die metallischen Bestandteile der Keramik für die stoffschlüssige Verbindung aufgeschmolzen werden können. Das Detektorelement ist durch den erfindungsgemäßen Aufbau des Sensorelements vor einer aggressiven Umgebung, wie sie insbesondere durch Kraftstoffdämpfe in einem Kraftstofftank gegeben sind, ausreichend geschützt, so dass die Lebensdauer deutlich erhöht ist. Ferner können das Abdeckelement und das Basiselement eine besonders einfache Geometrie aufweisen, so dass die Herstellung des erfindungsgemäßen Sensorelements entsprechend vereinfacht und somit kostengünstiger ist. Darüber hinaus ist es nicht zwingend notwendig, das Detektorelement zum Schutz mit einem Gießharz zu ummanteln. Zur verbesserten Lagefixierung des Detektorelements kann es ggf. vorteilhaft sein, den freien Raum innerhalb des Abdeckelements mit einem fließfähigen, elektrisch nicht leitfähigen, aushärtbaren Fluid zu verfüllen.

Das Detektorelement weist insbesondere einen Hallsensor auf, um das Magnetfeld des Magneten mit Hilfe des Halleffekts zu detektieren, indem eine Hallspannung gemessen wird. Vorzugsweise weist das Detektorelement zusätzlich oder alternativ einen AMR-Sensor (anisotrop magnetoresistiver Sensor) und/ oder einen GMR-Sensor (giant magneto resistance sensor) auf. Bei dem AMR-/ GMR-Sensor wird durch das Magnetfeld bzw. die Magnetfeldrichtung des Magneten der elektrische Widerstand, insbesondere eines kostengünstigen Ferrits, z. B. einer ferromagnetischen Schicht, verändert, wobei die Veränderung im Wesentlichen unabhängig von der Feldstärke des Magneten erfolgt. Dadurch sind spezielle Anforderungen an die Feldstärke des verwendeten Magneten nicht erforderlich. Der Magneto-Widerstandseffekt des AMR-/ GMR-Sensors kann mit Hilfe einer Brückenschaltung gemessen und vergleichbar zu einem Hallsensor in eine Spannungsänderung überführt werden. Ferner kann der AMR-/ GMR-Sensor im Vergleich zu einem Hallsensor deutlich kleiner ausgeführt sein.

Das Sensorelement weist vorzugsweise eine Abdeckkapsel auf. Die Abdeckkapsel weist das Abdeckelement und einen mit diesem verbundenen Deckel auf. Durch die Abdeckkapsel ist das Detektorelement ggf. zusammen mit dem Basiselement abgekapselt, d.h. vor einer aggressiven Umgebung geschützt. Der Deckel besteht vorzugsweise aus dem gleichen Material wie das Abdeckelement und ist mit diesem insbesondere stoffschlüssig, beispielsweise durch Löten, verbunden. Vorzugsweise ist das Basiselement vollständig innerhalb des Abdeckelements angeordnet. Dadurch ist es möglich, das Basiselement relativ zum Abdeckelement zu positionieren, ohne dass beispielsweise, wenn der Deckel mit dem Abdeckelement verbunden wird, eine ungewollte Lageveränderung des Basiselements auftritt. Ferner ist es möglich, die Verbindung des Deckels mit dem Abdeckelement an einer Stirnseite bzw. Schmalseite des Abdeckelements vorzunehmen. Dadurch ist es möglich, die Verbindungsfläche zwischen dem Deckel und dem Abdeckelement besonders klein auszuführen. Ferner kann die Verbindung zwischen Deckel und Abdeckelement, sofern möglich, an einem Ort erfolgen, der besonders weit von der aggressiven Umgebung entfernt ist. Dadurch ist der Schutz des Detektorelements weiter verbessert und die Lebensdauer erhöht.

In bevorzugter Ausführungsform weist das Abdeckelement und/ oder das Basiselement einen von dem Detektorelement weggerichteten Ansatz auf. Der Ansatz dient zur Begrenzung einer Einstecktiefe des Abdeckelements in einer Öffnung. Der Ansatz ist hierfür beispielsweise als abstehende Nase ausgeführt, so dass der Ansatz beim Hindurchführen des Sensorelements durch eine Öffnung an dem Bauteil, das die Öffnung aufweist, anschlägt, wodurch die maximale Einstecktiefe definiert wird. Mit Hilfe des Ansatzes ist es möglich, das erfindungsgemäße Sensorelement durch besonders einfache konstruktive Mittel als eigenständiges Modul für einen berührungslosen Füllstandgeber zu verwenden.

Der Ansatz kann beispielsweise durch eine Materialverdickung oder Materialaufweitung als Absatz ausgestaltet sein. Dadurch bildet sich eine Stufe aus, die als Anschlag zur Begrenzung der Einstecktiefe wirken kann. Insbesondere weist der Ansatz zu einer Außenseite des Abdeckelements bzw. des Basiselements einen rechten Winkel auf, der konkav ausgeführt ist. Die Anschlagfläche und die Außenseite sind also senkrecht zueinander ausgebildet, wodurch sich eine spitze Hohlkehle ergibt. In der Hohlkehle, d.h. in dem rechten Winkel, kann ein Dichtmittel, wie beispielsweise ein O-Ring, in einer definierten Lage angeordnet werden.

Vorzugsweise ist der Ansatz umlaufend ausgestaltet, so dass der Ansatz nicht nur als Anschlag, sondern zusätzlich als Spritzschutz wirkt, der aggressive Medien, wie beispielsweise Kraftstoff, von dem von dem aggressiven Medium abgewandten Teil des Sensorelements ableitet. Wenn das Abdeckelement vom aggressiven Medium aus gesehen hinter dem Ansatz mit einem Deckel oder dgl. verbunden ist, wird ein zusätzlicher Schutz des eingekapselten Detektorelements erreicht.

Die elektrischen Leiter des erfindungsgemäßen Sensorelements können als Kabel ausgeführt werden, die beispielsweise durch eine Öffnung nach außen geführt sind, wobei die Öffnung insbesondere mit Hilfe eines korrosionsbeständigen und diffusionsbeständigen Dichtmittels abgedichtet ist. Vorzugsweise ist zumindest einer der elektrischen Leiter als ein Leiterkanal ausgestaltet, der in dem Basiselement angeordnet ist. Das Basiselement ist somit vergleichbar zu einer Leiterplatine ausgestaltet, wobei diese "Platine" mehrschichtig ausgeschaltet ist, um die Leiter, vorzugsweise über die gesamte Umfangsfläche, zu ummanteln. Das Detektorelement kann durch einzelne Lötpunkte mit dem jeweiligen Leiter verbunden werden.

Zusätzlich bzw. alternativ kann das Abdeckelement bzw. ein mit dem Abdeckelement verbundener Deckel ein Kontaktelement zur Durchleitung von elektrischem Strom aufweisen. Das Kontaktelement ist vorzugsweise gegenüber dem Abdeckelement bzw. dem Deckel elektrisch isoliert und weist insbesondere einen möglichst geringen elektrischen Widerstand auf. Durch das Kontaktelement wird erreicht, dass elektrischer Strom das Abdeckelement, die Abdeckkapsel bzw. den Deckel passieren kann, wobei gleichzeitig ein Eindringen von aggressiven Medien aber vermieden wird.

Die Erfindung betrifft ferner einen berührungslosen Füllstandgeber, insbesondere für einen Kraftstofftank in einem Kraftfahrzeug. Der Füllstandgeber weist einen drehbar gelagerten Hebel auf, der mit einem Schwimmer und einem Magneten verbunden ist. In Abhängigkeit von der Position des Schwimmers wird der Hebel gedreht, wodurch sich die Positionen des Magneten verändert. Zwischen dem Magneten und einer Drehachse ist ein Sensorelement angeordnet, das insbesondere wie vorstehend beschrieben weiter ausgestaltet ist. Die Anordnung des Sensorelements erfolgt derart, dass sich das von dem Sensorelement gemessene magnetische Feld in Abhängigkeit von der Position des Schwimmers ändert.

Dadurch, dass das Sensorelement zwischen der Drehachse und dem Magneten angeordnet ist und nicht der Magnet zwischen der Drehachse und dem Sensorelement, ist der bewegbare Magnet weiter von der Drehachse beabstandet, so dass der Magnet bei einer Positionsänderung des Schwimmers eine größere Wegstrecke zurücklegt. Durch den längeren Bewegungsweg des Magneten erfolgt bei einer vergleichbaren Positionsänderung des Schwimmers eine stärkere Änderung des von dem Sensorelement gemessenen magnetischen Felds. Das Sensorelement kann somit entsprechend kleiner und kompakter ausgeführt sein und kann gleichzeitig den Füllstand mit einer höheren Genauigkeit messen. Ferner reicht es aus, nur das Detektorelement des Sensorelements vor Kraftstoffen und Kraftstoffdämpfen oder dgl. zu schützen, da die übrigen Bauteile keine empfindlichen elektrischen Bauelemente aufweisen. Der berührungslose Füllstandgeber kann deswegen entsprechend einfach ausgestaltet werden.

Der Magnet ist vorzugsweise zumindest als Segment eines Ringmagneten ausgeführt. Dadurch ergibt sich ein verhältnismäßig gleichmäßiges, ungestörtes Magnetfeld, das von dem Sensorelement gemessen wird. Zur weiteren Entstörung kann das Sensorelement mit Entstörbausteinen versehen werden, wodurch die Messgenauigkeit verbessert ist.

In bevorzugter Ausführungsform weist der Füllstandgeber ein Zwischenstück auf, mit dem der Hebel drehbar verbunden ist. Ferner weist das Zwischenstück eine Öffnung zur Aufnahme des Sensorelements auf. Das Sensorelement ist derart in der Öffnung angeordnet, dass das Detektorelement des Sensorelements der dem Hebel zugewandten Seite des Zwischenstücks zugeordnet ist. Das Sensorelement kann also beispielsweise außerhalb eines Kraftstofftanks über die Öffnung des Zwischenstücks, insbesondere teilweise, in den Kraftstofftank hineingeführt werden. Insbesondere weist das Sensorelement einen Ansatz auf, der als Anschlag an der dem Hebel abgewandten Seite des Zwischenstücks anliegt. Dadurch ist es insbesondere möglich, dass das Detektorelement vollständig gekapselt an der dem Hebel zugewandten Seite des Zwischenstücks anzuordnen, wobei gleichzeitig die Verbindung mit dem Deckel und die Leiterenden der Leiter an der dem Hebel abgewandten Seite des Zwischenstücks angeordnet sind. Durch diese Anordnung wird das Detektorelement des Sensorelements durch das Zwischenstück zusätzlich geschützt, beispielsweise, indem das Zwischenstück als Spritzschutz wirkt.

Die Erfindung betrifft ferner eine Füllstandgeberanordnung mit einem Kraftstofftank und einem mit diesem verbundenen Füllstandgeber, der insbesondere, wie vorstehend beschrieben, weiter ausgebildet ist. Der Kraftstofftank weist eine Aufnahmeöffnung zur Aufnahme eines Sensorelements oder eines Zwischenstücks auf. Das Sensorelement ist derart in der Aufnahmeöffnung geführt, dass das Detektorelement innerhalb des Kraftstofftanks und die Leiterenden der elektrischen Leiter außerhalb des Kraftstofftanks angeordnet sind. Sofern vorhanden, ist insbesondere die Verbindung zwischen einem Abdeckelement und einem Deckel des Sensorelements ebenfalls außerhalb des Kraftstofftanks angeordnet. Durch diese Anordnung kann mit Hilfe einfacher konstruktiver Mittel ein sicherer Schutz des Detektorelements vor dem Kraftstoff in dem Kraftstofftank erreicht werden. Durch den verbesserten Schutz des Detektorelements vor Kraftstoff bzw. Kraftstoffdämpfen ist die Lebensdauer der Füllstandgeberanordnung erhöht.

Nachfolgend wird die Erfindung anhand bevorzugter Ausführungsformen unter Bezugnahme auf die anliegenden Zeichnungen näher erläutert.

Es zeigen:

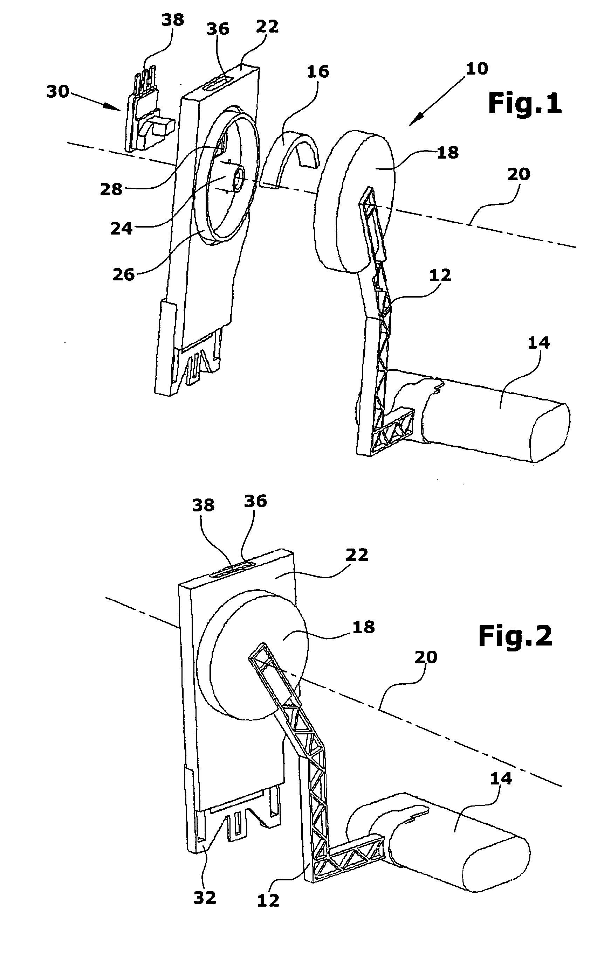

- Fig. 1:: eine schematische perspektivische Explosionsdarstellung eines erfindungsgemäßen berührungslosen Füllstandgebers,
- Fig. 2: eine schematische perspektivische Ansicht des Füllstandgebers aus Fig. 1,
- Fig. 3: eine schematische Schnittansicht einer ersten Ausführungsform eines erfindungsgemäßen Sensorelements in eingebautem Zustand,
- Fig. 4: eine schematische Schnittansicht einer zweiten Ausführungsform des eingebauten Sensorelements,
- Fig. 5: eine schematische Schnittansicht einer dritten Ausführungsform des eingebauten Sensorelements,
- Fig. 6: eine schematische Schnittansicht einer vierten Ausführungsform des eingebauten Sensorelements, und
- Fig. 7: eine schematische Schnittansicht einer fünften Ausführungsform des eingebauten Sensorelementes.

Der erfindungsgemäße berührungslose Füllstandgeber 10 weist einen Hebel 12 auf, der mit einem Schwimmer 14 und einem Magneten 16, der insbesondere als Segment eines Ringmagneten ausgeführt ist, verbunden ist. Der Magnet 16 ist mittelbar über ein erstes Gehäuseteil 18 mit dem Hebel 12 verbunden. Der Hebel 12 ist zusammen mit dem ersten Gehäuseteil 18 und dem Magneten 16 um eine Drehachse 20 schwenkbar mit einem Zwischenstück 22 verbunden. Das Zwischenstück 22 weist einen rohrförmigen Fortsatz 24 auf, über den der Hebel 12 gelagert ist. Hierzu weist der Hebel 12 bzw. das erste Gehäuseteil 18 einen Bolzen auf, der beispielsweise durch Klipsen mit dem Fortsatz 24 drehbar verbunden ist. Zur zusätzlichen Stabilisierung der Drehbewegung des Hebels 12 weist das Zwischenstück 22 einen zweiten Gehäuseteil 26 auf, der das erste Gehäuseteil 18 abstützt. Gleichzeitig halten das erste Gehäuseteil 18 und das zweite Gehäuseteil 26 Kraftstoff, der gegen den Füllstandgeber spritzen könnte, davon ab, in das Innere der Gehäuseteile 18, 26 einzudringen.

Das Zwischenstück 22 weist ferner eine Öffnung 28 zur Aufnahme eines Sensorelements 30 auf. Das Sensorelement 30 ist durch die Öffnung 28 derart angeordnet, dass es sich zwischen dem Magneten 16 und der Drehachse 20 befindet und das von dem Magneten 16 erzeugte Magnetfeld weitestgehend hysteresefrei misst. Das Zwischenstück 22 weist ferner ein Verbindungselement 32 auf, um den Füllstandgeber 10 mit einem Kraftstofftank 34 zu verbinden. Hierbei bildet das Zwischenstück 22 insbesondere einen Teil des Kraftstofftanks 34. Ggf. weist das Zwischenstück eine Durchführöffnung 36 auf, um elektrische Anschlüsse 38 des Sensorelements 30 zu einer Spannungsquelle bzw. einer Auswerteeinheit hindurchzuführen. In der Auswerteeinheit kann die von dem Sensorelement 30 aufgenommene Kennlinie weitverarbeitet werden, indem die Kennlinie beispielsweise programmiert und/ oder kalibriert wird.

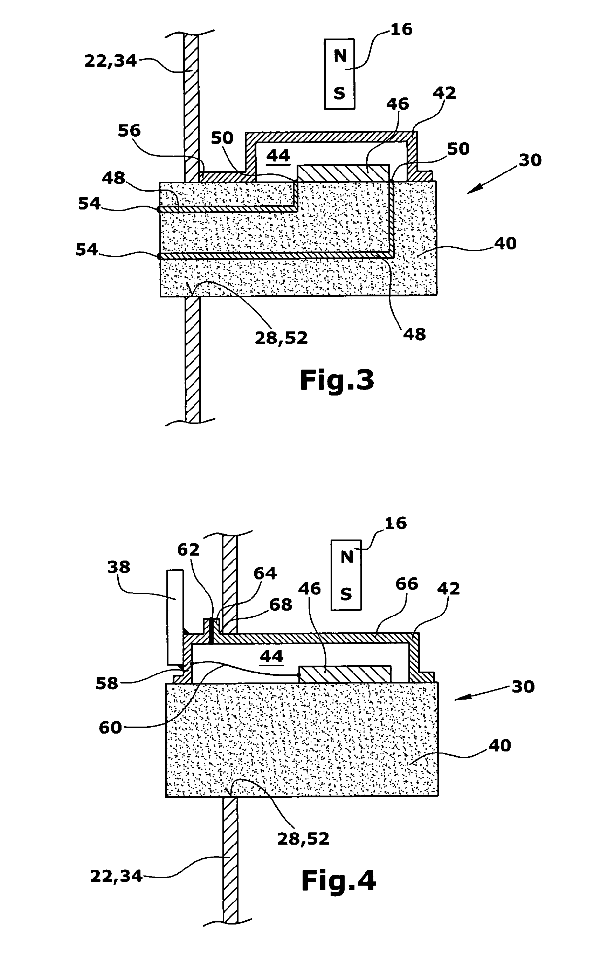

In der ersten Ausführungsform des Sensorelements 30 (Fig. 3) ist mit einem Basiselement 40 ein metallisches Abdeckelement 42 verlötet. Innerhalb eines durch das Basiselement 40 und das Abdeckelement 42 gebildeten, abgekapselten Raums 44 ist ein Detektorelement 46 angeordnet. Bei dem Detektorelement 46 kann es sich um ein Hallelement und/ oder einen AMR-Sensor und/ oder einen GMR-Sensor handeln. Das Detektorelement 46 ist auf dem keramischen Basiselement 40 aufgebracht. Das Basiselement 40 weist Leiterkanäle 48 auf, die über Lötstellen 50 mit dem Detektorelement 46 verbunden sind.

Das Sensorelement 30 ist in einer Öffnung geführt, bei der es sich um die Öffnung 28 des Zwischenstücks 22 oder um eine Aufnahmeöffnung 52 des Kraftstofftanks 34 handeln kann. Das Sensorelement 30 ist derart in der Öffnung 28 bzw. der Aufnahmeöffnung 52 geführt, dass das Detektorelement 46 innerhalb des Kraftstofftanks 34 angeordnet ist. Dadurch sind Leiterenden 54 der Leiterkanäle 48 außerhalb des Kraftstofftanks 34 angeordnet, wodurch die Leiterenden 54 außerhalb des Kraftstofftanks 34 in einer nicht aggressiven Umgebung über Lötpunkte oder dgl. mit elektrischen Kabeln oder Anschlüssen 38 verlötet werden können. Das Abdeckelement 42 ist in Fig. 3 von rechts in die Öffnung 28, 52 eingeführt. Zur Lagepositionierung weist das Abdeckelement 42 einen Absatz 56 auf, der als Anschlag die Einstecktiefe des Sensorelements 30 begrenzt. Dadurch ist es möglich, das Detektorelement 46 relativ zum Magneten 16 zueinander zentriert anzuordnen. Das Detektorelement 46 und der Magnet 16 sind also im Wesentlichen zueinander fluchtend ausgerichtet, so dass das Detektorelement 46 in einem im Wesentlichen homogenen, störungsfreien Magnetfeld angeordnet ist.

In der zweiten Ausführungsform des Hallsensor-Elelements 30 (Fig. 4) weist als Abdeckelement 42 Kontaktelemente 58 auf, die über elektrische Leiter 60 mit dem Detektorelement 46 verbunden sind. Die Kontaktelemente 58 sind jeweils mit einem elektrischen Anschluss 38, beispielsweise durch Löten, verbunden. Die Kontaktelemente 58 sind mit Hilfe eines Isolationsmittels 62 von dem übrigen Abdeckelement 42 isoliert ausgeführt, so dass Kurzschlüsse vermieden sind.

Das Abdeckelement 42 weist einen Ansatz 64 auf, der zu einer Oberfläche 66 des Abdeckelements 42 rechtwinklig ausgeführt ist. Es ergibt sich also zwischen dem Ansatz 64 und der Oberfläche 66 ein rechter Winkel 68. Bei der Montage wird das Sensorelement 30 in Fig. 4 von links in die Öffnung 28, 52 eingeführt, so dass der Ansatz 64 als Anschlag die Einstecktiefe begrenzt. Auf Grund des rechten Winkels 68 steht im eingebauten Zustand sowohl der Ansatz 64 als auch die Oberfläche 66 in Kontakt mit dem Zwischenstück 22 bzw. dem Kraftstofftank 34.

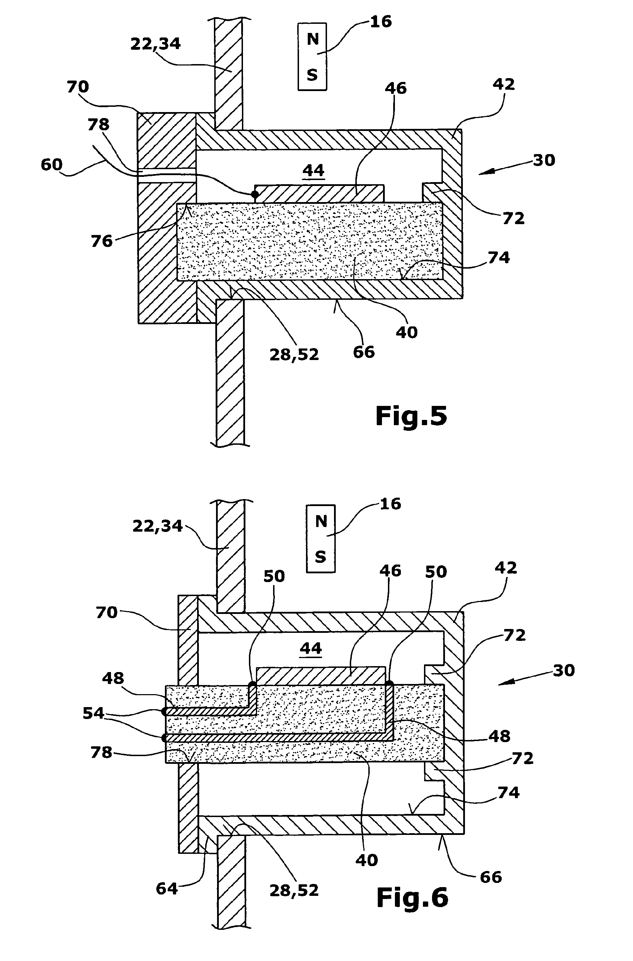

In der dritten Ausführungsform des Sensorelements 30 (Fig. 5) weist das Sensorelement 30 eine Abdeckkapsel auf, die aus dem Abdeckelement 42 und einem Deckel 70 besteht. Das Basiselement 40 ist vollständig innerhalb der Abdeckkapsel angeordnet. Das Abdeckelement 42 weist eine Nase 72 auf, die zu einem Boden 74 des Abdeckelements 42 einen Abstand aufweist, der mit der Dicke des Basiselements 40 korrespondiert. Dadurch ist es möglich, das Basiselement 40 lagefixiert mit dem Abdeckelement zu verbinden, so dass ein Verlöten entfallen kann. Entsprechend weist der Deckel 70 eine Vertiefung 76 auf, die ebenfalls mit der Dicke des Basiselements 40 korrespondiert. Das Basiselement 40 wird also sowohl von dem Abdeckelement 42 als auch von dem Deckel 70 gehalten.

Der Deckel 70 und das Abdeckelement 42 sind vorzugsweise stoffschlüssig, insbesondere durch Löten, miteinander verbunden. Um das Detektorelement 46 mit einer Auswerteeinheit bzw. einer Spannungsquelle zu verbinden, weist der Deckel 70 ferner einer Verbindungsöffnung 78 auf, durch welche die Leiter 60 hindurchgeführt werden können.

In der vierten Ausführungsform des Sensorelements 30 (Fig. 6) wird das Basiselement 40, das Leiterkanäle 48 aufweist, durch eine entsprechend groß ausgeführte Verbindungsöffnung 78 des Deckels 70 geführt, so dass die Leiterenden 54 außerhalb des Kraftstofftanks 34 angeordnet sind. Im Vergleich zu der in Fig. 5 dargestellten Ausführungsform des Sensorelements 30 ist die Vertiefung 76 durch den Deckel 70 hindurch als Verbindungsöffnung 78 ausgeführt, wodurch ein Bearbeitungsschritt für die Herstellung des Deckels 70 eingespart wird.

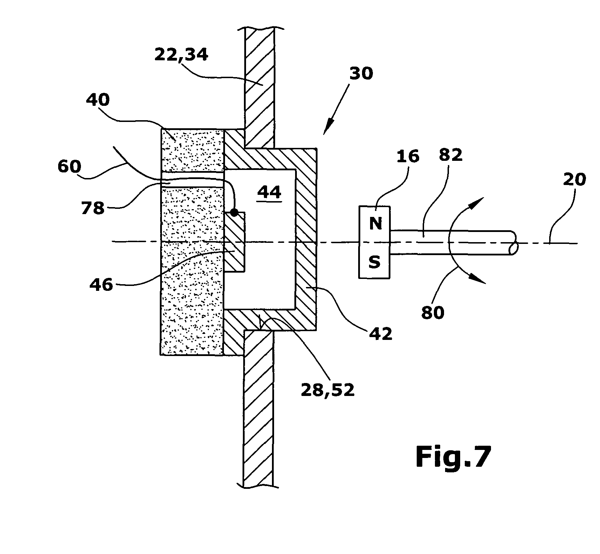

Das Sensorelement 30 kann im Vergleich zu den vorherigen Ausführungsformen auch um 90° gedreht eingebaut sein (Fig. 7). Diese Anordnung des Sensorelementes 30 bietet sich insbesondere an, wenn als Detektorelement 46 ein AMR-/ GMR-Sensor verwendet wird. Das Detektorelement 46 und der Magnet 16 sind vorzugsweise mittig zu der Drehachse 20 angeordnet, so dass sich bei einer Drehung des Magneten 16 in Richtung eines Pfeils 80 die Richtung des von dem Magneten 16 erzeugten Magnetfelds ändert. Die Änderung der Magnetfeldrichtung wird durch das Detektorelement 46 detektiert. In dieser Anordnung kann der Füllstandsgeber 10 beispielsweise anstatt des ersten deckelförmigen Gehäuseteils 18 eine Drehwelle 82 aufweisen, mit welcher der Magnet 16 verbunden ist. Insbesondere kann es sich bei dem Magneten 16 in dieser Ausführungsform um einen Stabmagneten handeln, so dass eine ringförmige Ausführung nicht erforderlich ist. Ferner kann das Sensorelement 30 an seiner Rückseite, d. h. an der vom Magneten 16 weg gerichteten Seite, mit einer Folie, insbesondere Klebefolie, verbunden sein. Dadurch kann das Sensorelement 30 besonders einfach mit dem Zwischenstück 22 bzw. dem Kraftstofftank 34 verbunden werden.

## Patentansprüche

1. Sensorelement zur Messung eines durch einen bewegbaren Magneten (16) erzeugten Magnetfeldes, mit
einem aus einem elektrischen Isolatormaterial bestehenden Basiselement (40),
einem mit dem Basiselement (40) verbundenen Detektorelement (46),
einem von dem Detektorelement (46) beabstandet mit dem Basiselement (40) verbundenen, metallischen Abdeckelement (42), und
mit dem Detektorelement (46) verbundenen und durch das Abdeckelement (42) und/ oder das Basiselement (40) geführte elektrische Leiter (60) zur Verbindung mit einer Spannungsquelle bzw. einer Auswerteeinheit.

2. Sensorelement nach Anspruch 1, **dadurch gekennzeichnet, dass** das Detektorelement (46) einen Hallsensor und/ oder einen AMR-Sensor und/oder einen GMR-Sensor aufweist.

3. Sensorelement nach Anspruch 1 oder 2, **gekennzeichnet durch** eine Abdeckkapsel, die das mit einem Deckel (70) verbundene Abdeckelement (42) aufweist.

4. Sensorelement nach einem der Ansprüche 1 - 3, **dadurch gekennzeichnet, dass** das Basiselement (40) vollständig innerhalb des Abdeckelements (42) angeordnet ist.

5. Sensorelement nach einem der Ansprüche 1 - 4, **dadurch gekennzeichnet, dass** das Abdeckelement (42) und/ oder das Basiselement (40) einen von dem Detektorelement (46) weggerichteten, insbesondere umlaufenden Ansatz (64), der vorzugsweise als Absatz (56) ausgestaltet ist, zur Begrenzung einer Einstecktiefe des Abdeckelementes (42) in einer Öffnung (28, 52) aufweist.

6. Sensorelement nach Anspruch 4 oder 5, **dadurch gekennzeichnet, dass** der Ansatz (64) zu einer vom Detektorelement (46) abgewandten Außenseite (66) einen konkaven rechten Winkel (68) aufweist.

7. Sensorelement nach einem der Ansprüche 1 - 6, **dadurch gekennzeichnet, dass** zumindest einer der elektrischen Leiter (60) als ein in dem Basiselement (40) angeordneter Leiterkanal (48) ausgestaltet ist.

8. Sensorelement nach einem der Ansprüche 1 - 7, **dadurch gekennzeichnet, dass** das Abdeckelement (42) zumindest ein Kontaktelement (58) zur Durchleitung von elektrischem Strom aufweist.

9. Berührungsloser Füllstandgeber, insbesondere für einen Kraftstofftank (34) in einem Kraftfahrzeug, mit
einem drehbar gelagerten Hebel (12), der mit einem Schwimmer (14) und einem Magneten (16) verbunden ist, und
einem Sensorelement (30) nach einem der Ansprüche 1 - 9,
wobei der mit dem Hebel (12) verbundene Magnet (16) zwischen dem Sensorelement (30) und einer Drehachse (20) des Hebels (12) derart angeordnet ist, dass in Abhängigkeit von der Position des Schwimmers (14) sich das von dem Sensorelement (30) gemessene magnetische Feld ändert.

10. Füllstandgeber nach Anspruch 9, **gekennzeichnet durch** ein Zwischenstück (22), mit dem der Hebel (12) drehbar verbunden ist und das eine Öffnung (28) aufweist, wobei das Sensorelement (30) derart in der Öffnung (28) angeordnet ist, dass das Detektorelement (46) der dem Hebel (12) zugewandten Seite des Zwischenstücks (22) zugeordnet ist und insbesondere der Ansatz (64) des Sensorelements (30) an der dem Hebel (12) abgewandten Seite des Zwischenstücks (22) als Anschlag anliegt.

11. Füllstandgeberanordnung mit einem Kraftstofftank (34) und einem Füllstandgeber (10) nach Anspruch 9 oder 10, wobei der Kraftstofftank (34) eine Aufnahmeöffnung (52) zur Aufnahme eines Sensorelements (30) oder Zwischenstücks (22) aufweist, durch die das Sensorelement (30) derart geführt ist, dass das Detektorelement (46) innerhalb des Kraftstofftanks (34) und Leiterenden (54) der elektrischen Leiter (60) außerhalb des Kraftstofftanks (34) angeordnet sind.
